# EUROPEAN PATENT SPECIFICATION

(11) **EP 2 880 691 B1**
(45) Date of publication and mention of the grant of the patent: **05.10.2016**
(21) Application number: 13753719.7
(22) Date of filing: 06.08.2013
(51) Int. Cl.: H01L 31/0224, H01L 31/048, H01L 31/18, H02S 20/26

(54) **HIGH RELIABILITY PHOTO-VOLTAIC DEVICE**
HOCHZUVERLÄSSIGE PHOTOVOLTAIKVORRICHTUNG
DISPOSITIF PHOTOVOLTAÏQUE À HAUT NIVEAU DE FIABILITÉ

(30) Priority: 06.08.2012 US 201261679977 P
(43) Date of publication of application: 10.06.2015
(73) Proprietor: Dow Global Technologies LLC, Midland, MI 48674 (US)
(72) Inventor: NAMJOSHI, Abhijit, Midland, MI 48640 (US); CAPALDO, Kevin, P., Midland, MI 48640 (US); CLARK, Lindsey, A., Midland, MI 48642 (US); DEGROOT, Marty, W., Middletown, DE 19709 (US); FEIST, Rebekah, K., Midland, MI 48642 (US); LOPEZ, Leonardo, C., Midland, MI 48640 (US); MILLS, Michael, E., Midland, MI 48642 (US); STEMPKI, Matt, Midland, MI 48640 (US)
(74) Representative: Beck Greener
(86) International application number: PCT/US2013/053859
(87) International publication number: WO 2014/025826

(56) References cited:
- EP-A1- 2 068 372
- EP-A2- 1 928 027
- WO-A2-2012/085084
- JP-A- 2005 277 199
- US-A- 5 672 214
- US-A1- 2009 285 976

## Description

### FIELD

The present invention relates to improved photo-voltaic devices, and more particularly but not exclusively relates to photo-voltaic devices having an enhanced interconnect reliability and improved resistance profile over time.

### INTRODUCTION

Presently known photo-voltaic (PV) devices include an active solar area which is the portion of the PV device where photons are received and converted to electrically available energy. PV devices include conductive elements coupled to each cell which collect current from the cells, and thereby interconnect the cells. An effective presently known interconnection scheme utilizes screen printed inks on each cell, and electrically conductive adhesives (ECAs) connecting cells. ECAs and conductive inks include conductive particles dispersed in a matrix. An example ECA includes silver particles in a polymeric matrix.

Another presently known interconnection scheme includes conductors placed directly on the top layer of the cell, which top layer is often a transparent conductive oxide (TCO) layer. Plastic or polymeric materials are utilized to hold down the conductors to the TCO. As the plastic or polymeric material relaxes over time, the resistance in the cell interconnection circuit increases, leading to degraded module power performance.

It is desirable with building integrated PV (BIPV) devices that the PV device have a similar life span to comparable building elements that do not include PV devices. The lifespan of the BIPV system also need to be reasonably long to provide value to the customer as a roofing product and as a power generation device that provides a return on the investment in the device. It is also desirable that construction materials and operations are usable with existing products and processes with little or no modifications to the existing products and processes.

Among the literature that can pertain to this technology includes US 2008/0314432, US 2009/0235979, and US 2011/0197947.

### SUMMARY

The present disclosure in one aspect includes an article of manufacture having a photovoltaic (PV) element, the PV element including a conductive layer positioned on a light-incident side of the PV element. The article further includes a conductor electrically coupled to the conductive layer, a conductive particle matrix positioned between the conductor and the conductive layer at a number of positions on the conductive layer. The article further includes a carrier film positioned on the light-incident side of the PV element, and a non-conductive adhesive, where the adhesive and the conductor are positioned between the carrier film and the conductive layer.

Additional or alternative aspects of the disclosure may be further characterized by any one or more of the following features: the conductive particle matrix being a printed ink; the conductive particle matrix including conductive particles which are copper, silver, gold, silver coated copper, gold coated copper, and/or gold coated silver particles; the conductor including Sn, Al, Cu, In, Sn-plated Cu, and/or Cu alloys (e.g. brass); the conductive particle matrix including a conductive ink, where the conductor includes a wire mesh having the conductive ink applied thereto (e.g. by screen printing onto the wire mesh), and applied to the conductive layer; where the conductor includes a number of conductive members and where the conductive particle matrix is further positioned between the conductive layer and only a portion of the number of conductive layers, and/or wherein the portion is a value between 1/10 and 9/10 of the number of conductive members; where the conductive particle matrix is further positioned between the conductive layer and a first fraction of an area including a conductor-conductive layer apparent contact area; where the first fraction includes a value of less than 1%, between 1% an 10%, between 10% and 25%, between 25% and 50%, and/or between 50% and 100% , all values inclusive, of the conductor-conductive layer apparent contact area; where an optical coverage area of the conductor includes a fraction of a solar active area of the PV element, where the fraction includes a value between 2% and 3%, between 3% and 5%, between 5% and 7%, and/or between 7% and 10%, all inclusive, of the solar active area; wherein an optical coverage area of the conductive particle matrix includes a fraction of a solar active area of the PV element, where the fraction includes a value between 0.02% and 0.1%, between 2% and 10%, between 1% and 2%, between 2% and 3%, between 3% and 5%, between 5% and 7%, and/or between 7% and 10%, all inclusive, of the solar active area; and the conductor including a physically continuous portion, where the conductive particle matrix is further interposed between the physically continuous portion and the conductive layer at a number of positions which are physically discontinuous portions of the conductive particle matrix.

An additional or alternative aspect of the present disclosure is a method including interpreting a first degradation characteristic of a nominal PV element having a conductor and a conductive layer with no conductive particle matrix therebetween; interpreting a degradation characteristic function and a cost differential function of a PV element having a conductive particle matrix interposed between a conductor and a conductive layer of the PV element, the degradation cost function and the cost differential function being functions of a design selection parameter of the conductive particle matrix; and providing a PV element design in response to the first degradation characteristic, the degradation characteristic function, the cost differential function, and the design selection parameter.

Additional or alternative aspects of the disclosure may be further characterized by any one or more of the following features: considering a shadowing effect of the conductive particle matrix, considering a shadowing effect of the conductor, considering a materials cost of the conductive particle matrix, considering a manufacturing cost of the conductive particle matrix, considering a shadowing effect to the cost of power generation and overall module costs, and/or considering integrated power generated over time.

### BRIEF DESCRIPTION OF THE DRAWINGS

Fig. 1 is a schematic diagram of a layered PV element having a conductive particle matrix positioned between one of a number of conductors and a conductive layer.
Fig. 2 is a closer view of a conductive particle matrix positioned between one of a number of conductors and a conductive layer.
Fig. 3 is a schematic diagram of a number of conductor elements and a conductive particle matrix.
Fig. 4 is a schematic diagram of a number of conductor elements formed as a physically continuous portion, and the conductive particle matrix positioned between the physically continuous portion and the conductive layer at a number of positions formed as a physically discontinuous portion.
Fig. 5 is a schematic diagram of a number of conductor elements and a conductive particle matrix.
Fig. 6 is a schematic diagram of a number of conductor elements and a conductive particle matrix.
Figs. 7a and 7b are schematic diagrams of a number of conductor elements and a conductive particle matrix.
Figs. 8a and 8b are schematic diagrams of a number of conductor elements and a conductive particle matrix.
Fig. 9 compares data between a device having certain features of the present disclosure and a previously known device.
Fig. 10 compares data between a device having certain features of the present disclosure and a previously known device.
Fig. 11 compares data between a device having certain features of the present disclosure and two previously known devices.

### DETAILED DESCRIPTION

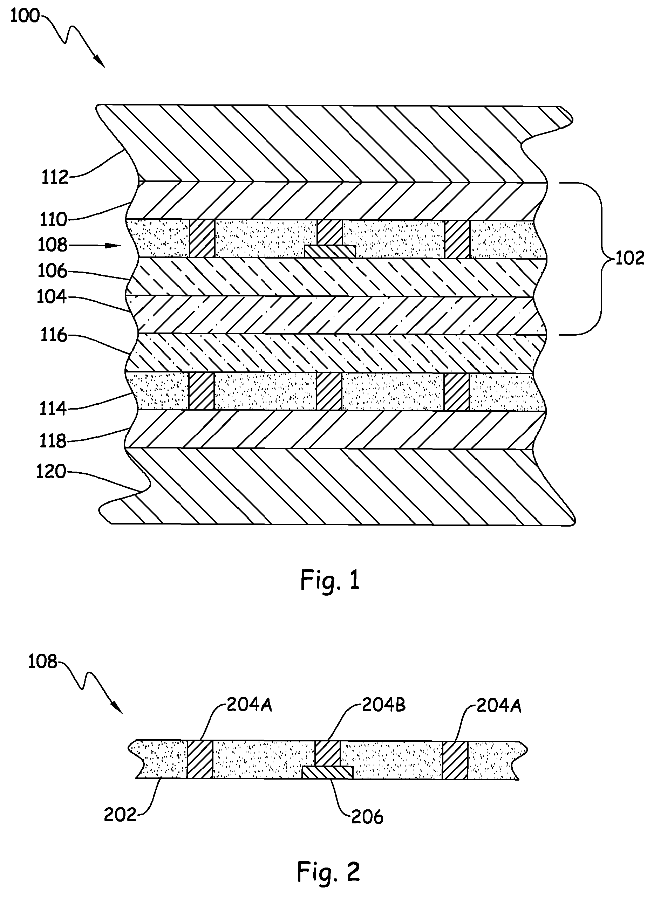

Referencing Fig. 1, a cutaway view of a portion of a PV device 100 is depicted. The device 100 includes a PV element 102 having a conductive layer 106 positioned on a light-incident side (vertically upward in the orientation depicted in Fig. 1) of the PV element 102. The PV element 102 in the example of Fig. 1 includes a junction 104 which includes a semi-conductor that generates electrical current in response to incident photons having energy levels corresponding to certain wavelength ranges, and the conductive layer 106. The conductive layer 106 allows photons to reach the junction 104, and is therefore at least partially transparent with respect to photons in the wavelength ranges relevant to the junction 104. An example and non-limiting conductive layer is a transparent conductive oxide such as a doped metal oxide.

The conductive particle matrix 206 depicted in Fig. 2 may be provided as a material having conductive particles in a matrix therein. In one example, the matrix is applied to a surface of the conductive layer 106 and dried, or may be cured (e.g. at a specified time, temperature, and/or humidity level), leaving well bonded particles to the surface of the conductive layer 106. The particles include conductive materials. Example materials for the conductive particles include copper, silver, gold, silver coated (or plated) copper, gold-plated copper, gold-plated silver, silver coated stainless steel, silver coated tin, a silver coated metal, and/or a gold coated metal. In certain embodiments, the conductive particles include one or more of the described materials, but may include additional materials. In certain embodiments, the conductive particles include conductive materials other than those described, including any material that is conductive, manufacturable into a suitable form, and having an operational life under the expected operating conditions of the PV device 100 that is appropriate to the application of the PV device. Referencing Fig. 2, the conductive particle matrix 206 is provided between the conductor 204b and conductive layer 106 at a number of positions across the surface of the conductive layer 106. The example in Figs. 1 and 2 depicts a single one of three conductors having the conductive particle matrix 206 positioned thereunder. The device 100 in Fig. 1 illustrates one example at a single position within the system, although any number of the conductors 204 may include portions of the conductive particle matrix 206 positioned thereunder at various positions, or at all positions.

The PV element 102 further includes a layer 108. Referencing Fig. 2, the layer 108 includes conductors 204a, 204b positioned between the conductive layer 106 and a carrier film 110, where the conductors 204a, 204b are electrically coupled to the conductive layer 106. The conductors 204a, 204b may be any material known in the art, including without limitation tin, aluminum, copper, indium, and/or tin-plated copper. In certain embodiments, the conductors 204a, 204b do not include any noble metals. Additionally or alternatively, the conductors 204a, 204b include a noble metal as a plating or coating. In still further embodiments, the conductors 204a, 204b do not include any noble metal content. In the example of Fig. 1, and/or Fig. 2, a conductive particle matrix 206 is positioned between the conductor 204b and the conductive layer 106.

The article 100 further includes the carrier film 110 positioned on the light-incident side of the PV element. The article further includes an adhesive 202 in the layer 108 with the conductors 204a, 204b. The adhesive 202 is a non-conductive adhesive. The adhesive 202 and the conductors 204a, 204b are positioned between the carrier film 110 and the conductive layer 106. Additionally or alternatively, the device 100 includes an encapsulation layer 112 on the light-incident side. The encapsulation layer provides protection from shock, humidity, impact, etc., for the PV device. Further details of the encapsulation layer are omitted to avoid obscuring features of the present disclosure. The PV element 102 is depicted including the junction 104, the conductive layer 106, the layer 108 including the adhesive 202 and the conductors 204, the conductive particle matrix 206, and the carrier film 110. However, the PV element 102 may include additional elements, or may omit one or more of the depicted elements, in certain embodiments. The PV element 102 may exist as a portion of an integrated PV device 100. Layers 106, 202, 110, and 112 are transparent or partially transparent, at least at wavelengths of interest. All layers below layer 104 are not confined to be transparent. Layers 204, 206 can be opaque or transparent.

On the side away from the light incident side, the device 100 includes a second conductive layer 116. The second conductive layer 116 is not constrained to be transparent or partially transparent. An example second conductive layer 116, without limitation, is a metallic conductive layer. The example device 100 includes an adhesive/conductor layer on the side away from the light incident side, adjacent to the second conductive layer 116. The example device 100 includes a carrier film 118 and encapsulation layer(s) 120 also on the side away from the light incident side. The encapsulation layer 120 may differ from the encapsulation layer 112. The encapsulation layer 120 may be opaque, and may be provided to give the device 100 some flexibility or surface conformity to the device, to protect from environmental intrusion, and/or to provide puncture resistance, such as from protruding nails on a rooftop wherein the PV device 100 will be installed.

In certain embodiments, the PV device 100 is formed as a building integrated photovoltaic (BIPV) module. The BIPV module is formed as a physical replacement for a building integrated construction element, for example a roofing shingle. The BIPV module may be sized to replace a single building integrated construction element, to replace a number of building integrated construction elements, and/or to cooperate with a number of BIPV modules to replace a number of building integrated construction elements. Additionally or alternatively, the BIPV module may be sized and constructed to perform the functions of a building integrated construction element without regard to the size of a standard construction element.

An example BIPV module integrates the PV device 100, including a photovoltaic (PV) element 102 having a conductive layer 106 positioned on a light-incident side of the PV element 102, a conductor 204 electrically coupled to the conductive layer 106, a conductive particle matrix 206 interposed between the conductor 204 and the conductive layer 106 at a plurality of positions on the conductive layer 106, a carrier film 110 positioned on the light-incident side of the PV element 102, a non-conductive adhesive 202, where the adhesive 202 and the conductor 204 are interposed between the carrier film 110 and the conductive layer 106. The BIPV module further includes a light-incident encapsulation layer 112 positioned on the light incident side of the carrier film 110. The BIPV module further includes a building side conductive layer 116, a building side conductor (within layer 114), and a building side encapsulation layer 120 positioned on a building side of the PV element. The building side construction of the BIPV module, in certain embodiments, is of a conventional construction. However, in alternative embodiments, the building side construction of the BIPV module may include conductors and a conductive layer, with a conductive particle matrix positioned between the conductors and the conductive layer at a number of positions on the building side conductive layer 116. The conductors 204 on the light-incident side, in certain embodiments, are at least partially made up of tin, aluminum, copper, indium, tin-plated copper, and/or a copper alloy.

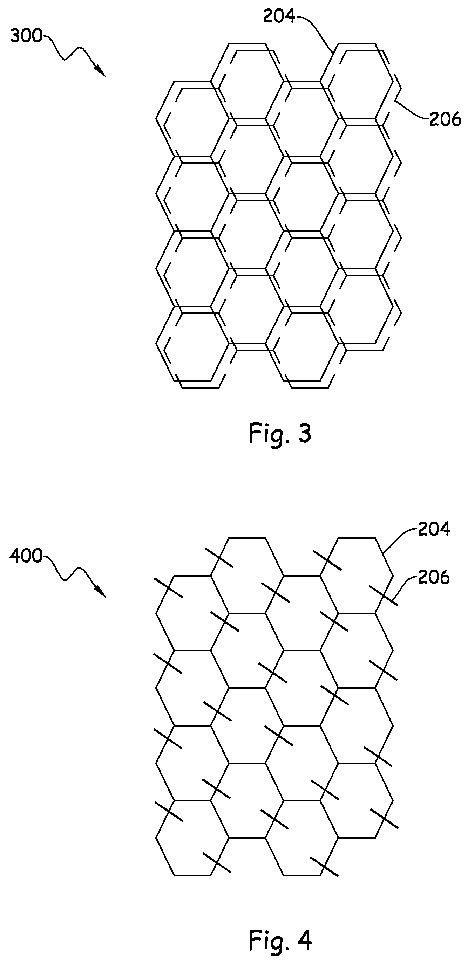

Referencing Fig. 3, an example arrangement 300 of conductors 204 and conductive particle matrix 206 is depicted. The illustration of Fig. 3 may be just a portion of a layer of conductors 204, which may be overall sized to fit a solar cell of a PV device, or to fit a portion of a solar cell of the PV device. The conductive particle matrix 206 is illustrated in dotted line form to distinguish the conductive particle matrix 206 from the conductors 204. However, the conductive particle matrix 206 may be physically continuous or discontinuous. The conductors 204 are prepared as a wire mesh, the wire material being any conductive material. The arrangement described herein provides for improved reliability and reduced conductivity loss over time and wear, allowing for lower cost materials to be utilized for the conductors 204.

A PV device utilizing the conductors 204 and conductive particle matrix 206 may be prepared by any manufacturing method. An example, non-limiting manufacturing method includes providing the conductive particle matrix 206 as a screen printed conductive ink onto a conductive layer 106 surface, curing the conductive particle matrix 206, and laying the wire mesh of the conductors 204 onto the cured ink. Additionally or alternatively, the conductive particle matrix 206 may be positioned by any manufacturing technique, including at least ink jet printing, stamping, spraying, and/or painting. A non-conducting adhesive layer is added to complete the layer 108, and a carrier film 110 is positioned over the layer 108. Encapsulation layers 112 or other manufacturing operations, as understood in the art, are added to complete the PV device. The conductors 204 and conductive particle matrix 206 are applied to the light incident side of the PV device, and the non-light incident side of the PV device is manufactured conventionally.

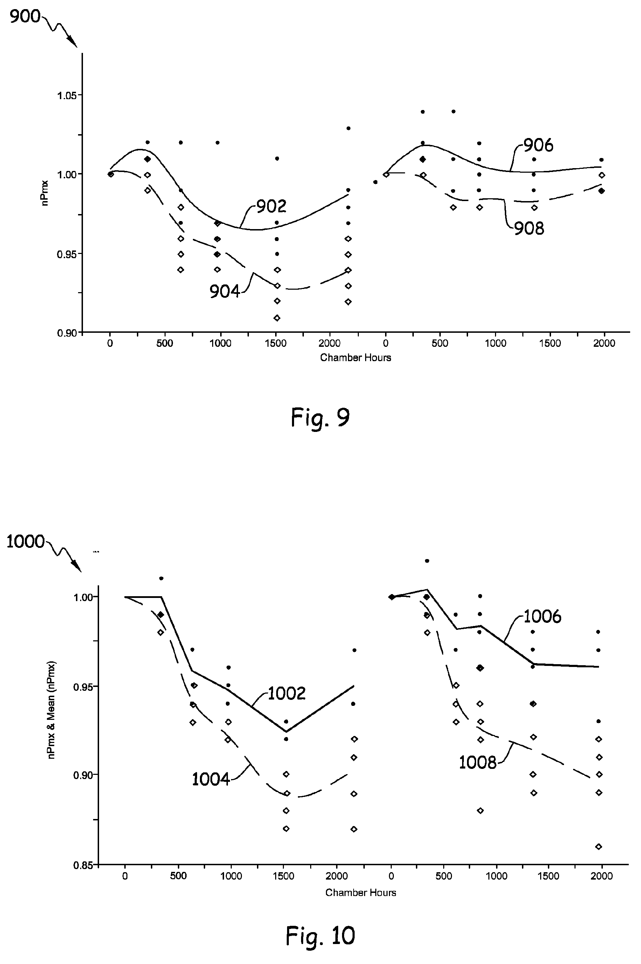

The conductive particle matrix 206 provides multiple additional conductive paths from the conductive layer 106 to the conductors 204. Referencing Fig. 9, experimental data 900 for a system is depicted. The curve 902 represents power output after aging in environmental chambers normalized by the pre-aged power of the device for a PV device having a wire mesh placed over a conductive ink screen printed pattern onto a conductive layer, and the curve 904 represents normalized power output for a PV device having a wire mesh placed in direct contact with a conductive layer as is known in some conventional devices. The experimental data 900 is generated with PV device samples having an edge seal. The samples are aged in a chamber at 85° C and ambient humidity, and curves 902, 904 are generated at room temperature. The curve 906 represents normalized power output for a PV device having a wire mesh placed over a conductive ink screen printed pattern onto a conductive layer, and the curve 908 represents normalized power output for a PV device having a wire mesh placed in direct contact with a conductive layer as is known in some conventional devices. It can be seen that the interposition of the conductive particle matrix between the conductor and the conductive layer improves the normalized power output over time for both dry heat and humid heat conditions.

Referencing Fig. 10, experimental data 1000 for a system is depicted. The curve 1002 represents power output after aging in environmental chambers normalized by the pre-aged power of the device for a PV device having a wire mesh placed over a conductive ink screen printed pattern onto a conductive layer, and the curve 1004 represents normalized power output for a PV device having a wire mesh placed in direct contact with a conductive layer as is known in some conventional devices. The experimental data 1000 is generated with PV device samples having no edge seal. The samples are aged in a chamber at 85° C and ambient humidity, and curves 1002, 1004 are generated at room temperature. The curves 1002, 1004 are generated at room temperature. The curve 1006 represents normalized power output for a PV device having a wire mesh placed over a conductive ink screen printed pattern onto a conductive layer, and the curve 1008 represents normalized power output for a PV device having a wire mesh placed in direct contact with a conductive layer as is known in some conventional devices. With regard to curves 1006, 1008, the samples are aged in a chamber at 85° C and ambient humidity, and curves 902, 904 are generated at room temperature. It can be seen that the interposition of the conductive particle matrix between the conductor and the conductive layer improves the normalized power output over time for both dry heat and humid heat conditions. The experimental data 1000 suggests that the differences between a PV device according to the present disclosure and a conventional PV device are even greater under non-optimal conditions, for example when a humidity barrier for the PV device has failed or degraded.

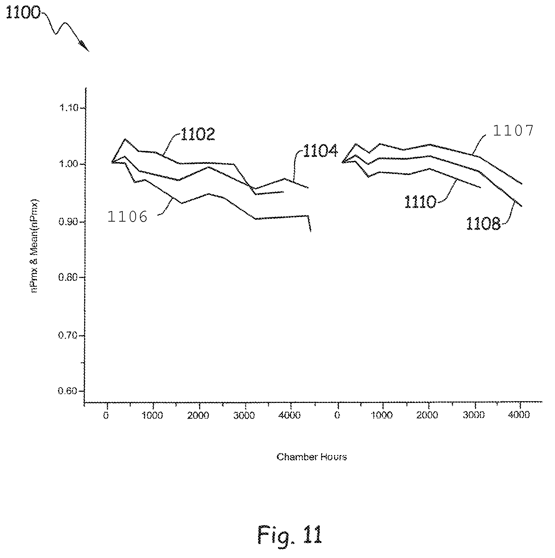

Referencing Fig. 11, experimental data 1100 for a system is depicted. The curves 1102, 1107 represent power output after aging in environmental chambers normalized by the pre-aged power of the device for a PV device having a wire mesh placed over a conductive ink pattern onto a conductive layer, the curves 1104, 1108 represent normalized power output for a PV device having only a conductive ink screen printed pattern onto a conductive layer, and the curves 1106, 1110 represent normalized power output for a PV device having only a wire mesh placed onto the conductive layer. In the example of Fig. 11, the conductive ink is screen printed on to the conductive layer. Then, before the ink is cured, a conductor in the form of wire mesh is added on to the top of the ink. The carrier film and adhesive are also attached to the conductor. The curves 1102, 1104, 1106 are generated at 85° C and ambient relative humidity, and the curves 1107, 1108, 1110 are generated at 85° C and 85% relative humidity.

It can be seen that, over about 3000 hours, the curve 1104 exceeds the curve 1102. This could be due to an anomaly in the experimental results. However, even if the exhibited crossover is real, the curve 1102 exhibits a higher normalized power output for a significant operating time. Depending upon the application, the normalized power output at early times may be a consideration, and/or the total area under the normalized power output may be a consideration. At the high humidity values, the curve 1107 exhibits improved normalized power output over the other configurations for all time values in the data 1100. Overall in the data 900, 1000, 1100, it can be seen that the disclosed PV device exhibits improved normalized power output at a variety of operating conditions, especially higher humidity and/or off-nominal conditions, relative to comparative configurations.

Referencing Fig. 4, an example arrangement 400 of conductors 204 and conductive particle matrix 206 is depicted. The arrangement of conductors 204 is similar to the arrangement in Fig. 3. The conductive particle matrix 206 is provided as a series of strategically positioned discontinuous portions that intersect the conductors 204 in a selected pattern. If one considers each side of one of the hexes of the conductors 204 as one conductive member, and the whole of the sides of the hexes as the total number of conductive members, it can be seen that the conductive particle matrix 206 is positioned between the conductor 204 and a conductive layer beneath (not shown in Fig. 4) for only a portion of the conductive members. The arrangement 400 illustrates 68 total conductive members, and 22 of the conductive members are contacted by the conductive particle matrix 206, indicating that the portion of the conductive members having the conductive particle matrix 206 positioned between the conductive member and the conductive layer is 22/68, or nearly 1/3 of the conductive members.

The selected portion of the conductive members having the conductive particle matrix 206 positioned between the conductive member and the conductive layer may be any value. Examples include as few as 1/10^{th} of the total number of conductor members to as high as 9/10^{th} of the total number of conductive members. In certain embodiments, the portion may include as few as 1/100^{th} of the total number of conductive members, and as high as all of the conductive members. Additionally or alternatively, one or more of the conductive particle matrix 206 segments may be connected, and/or the entire conductive particle matrix 206 may be continuous (e.g. as shown in Fig. 3).

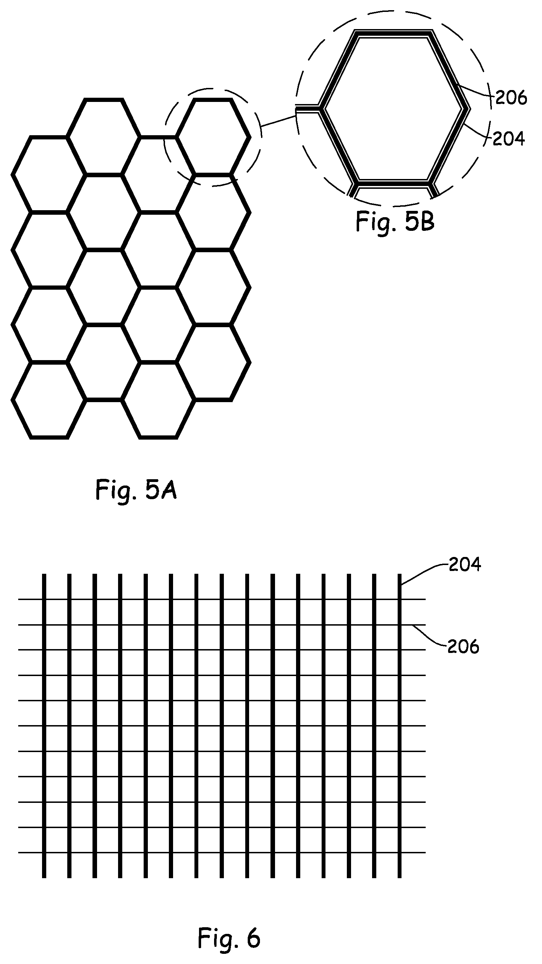

Referencing Fig. 5, another example arrangement of the conductors 204 and conductive particle matrix 206 is depicted. The conductive particle matrix 206 is depicted in a lighter gray, and encompasses the areas wherein the conductors 204 are positioned. The conductive particle matrix 206 positioning in Fig. 5 may be achieved by placing and curing the conductive particle matrix 206 in a pattern that will be utilized for positioning the conductors 204, and/or by placing the conductive particle matrix 206 directly onto the conductors (e.g. dipping a wire mesh into a conductive ink) and then placing the conductors onto the conductive layer and executing a curing operation. The arrangement in Fig. 5 can be utilized for the entire conductor 204 layer, or for portions of the conductor 204 layer.

Referencing Fig. 6, another example arrangement of the conductors 204 and conductive particle matrix 206 is depicted. The conductive particle matrix 206 includes the horizontal lines, and the conductors 204 include the vertical lines. Alternatively or additionally, some of the vertical and/or horizontal lines may include both conductor 204 and/or conductive particle matrix 206 members.

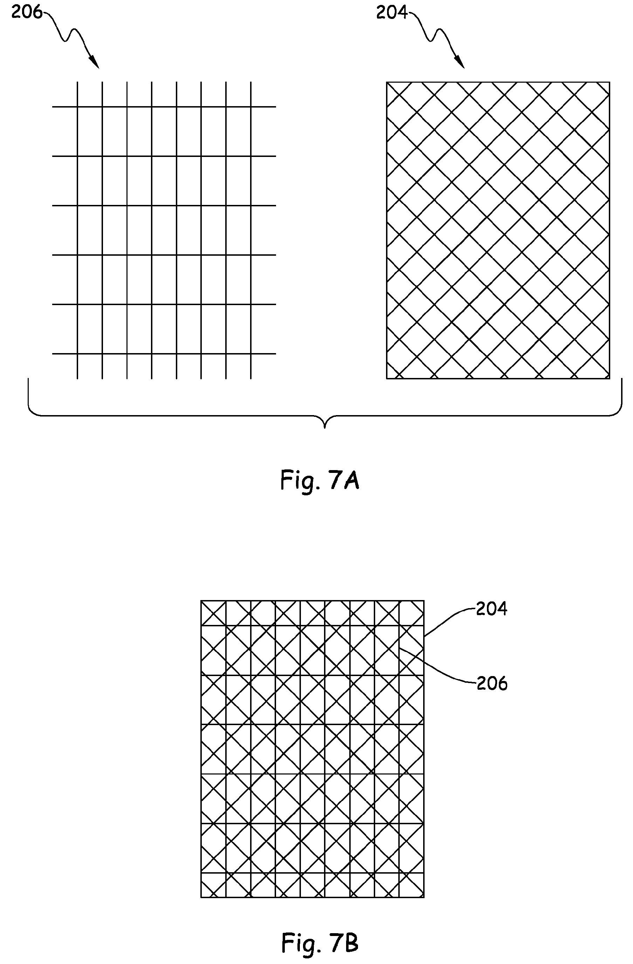

Referencing Fig. 7a, another example arrangement of the conductors 204 and conductive particle matrix 206 is depicted. Fig. 7a illustrates the conductors 204 and the conductive particle matrix 206 separately to aid visualization of the arrangement. Fig. 7b illustrates the conductors 204 positioned onto the conductive particle matrix 206, which is positioned onto the conductive layer (not shown). An arrangement such as that shown in Fig. 7b is robust to spot degradation at points on the conductive layer, as there is circuit redundancy from a given position within the conductors 204 or the conductive particle matrix 206.

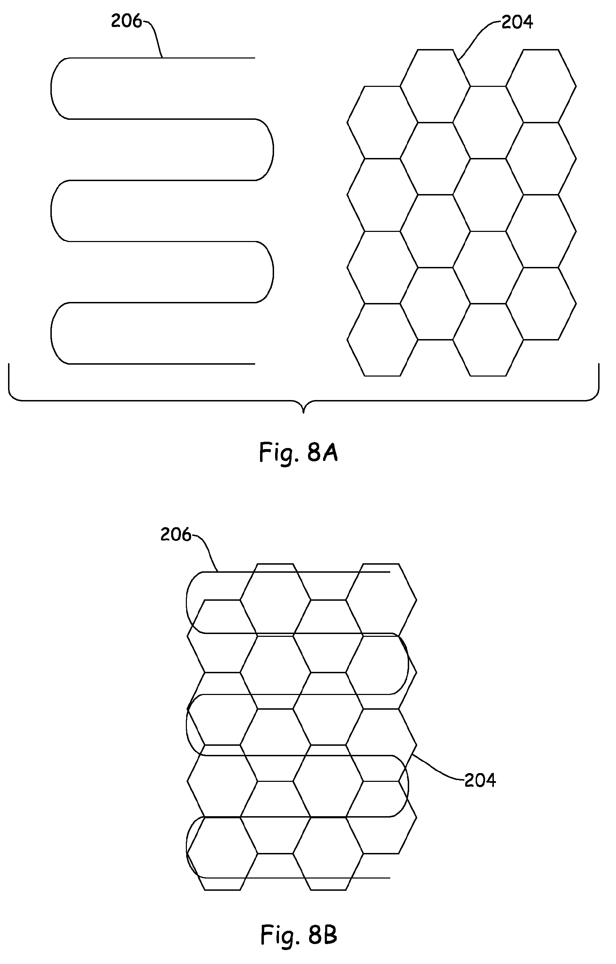

Referencing Fig. 8a, another example arrangement of the conductors 204 and conductive particle matrix 206 is depicted. Fig. 8a illustrates the conductors 204 and the conductive particle matrix 206 separately to aid visualization of the arrangement. Fig. 8b illustrates the conductors 204 positioned onto the conductive particle matrix 206, which is positioned onto the conductive layer (not shown). An arrangement such as that shown in Fig. 8b is robust to spot degradation at points on the conductive layer, as there is circuit redundancy from a given position within the conductors 204 or the conductive particle matrix 206.

All of the arrangements depicted in Figs. 3 through 8b are non-limiting examples. In certain embodiments, an arrangement includes the conductive particle matrix positioned between the conductive layer and a fraction of an area that includes the conductor-conductive layer apparent contact area. The conductor-conductive layer apparent contact area is the nominal physical area under the conductors, which ideally provides electrical contact between the conductors and the conductive layer, but which may not be effectively electrically connected under certain conditions such as after degradation of the PV device over time. The fraction of the conductor-conductive layer apparent contact area that includes conductive particle matrix positioned therebetween may be less than 1%, between 1% and 10%, between 10% and 25%, between 25% and 50%, or greater than 50%. The conductive particle matrix may be positioned over additional area that is not in the conductor-conductive layer apparent contact area, for example as illustrated in Figs. 3 and 4.

In certain embodiments, an optical coverage area includes the total visual coverage area of the conductors from the perspective of the light incident side of the PV device. In certain embodiments, the total optical coverage area, represented as a fraction of a total active solar area of the PV device, may be as low as 2-3% of the solar active area. Alternatively, the optical coverage area of the conductor may be 3-5%, 5-7%, or 7-10% of the total active solar area of the PV device.

In certain embodiments, a conductive particle matrix optical area of the conductive particle matrix includes the total visual coverage area of the conductor from the perspective of the light incident side of the PV device. The conductive particle matrix shares some optical area with the conductor, but may be positioned such that the conductive particle matrix optical area is fully included within the conductor optical coverage area, such that the conductive particle matrix optical area is coextensive with the conductor optical coverage area, or such that the conductive particle matrix optical area includes portions outside the conductor optical coverage area.

In certain embodiments, for example where the conductive particle matrix optical area is fully included within and/or coextensive with the conductor optical coverage area, the conductive particle matrix optical area is directly related to a total percentage of the area of the optical coverage area having conductive particle matrix positioned between the conductor and the conductive layer. Accordingly, where the conductive particle matrix provides 1% coverage of the conductor, and the optical coverage area of the conductor is 2% of the total active solar area, the conductive particle matrix optical area is 0.02% of the total active solar area. In another example, where the conductive particle matrix provides 100% coverage of the conductor, and the optical coverage area of the conductor is 10% of the total active solar area, the conductive particle matrix optical area is 10% of the total active solar area.

In certain embodiments, for example where the conductive particle matrix is provided in a specified pattern that includes some portions intersecting the conductors and other portions that are not between the conductor and the conductive layer, the conductive particle matrix is simply the percentage of the solar active area covered by the specified pattern, and the relationship to the optical coverage area of the conductor does not necessarily help in understanding the conductive particle matrix optical area. However, the area of intersection between the conductive particle matrix optical area and the optical coverage area of the conductor is still a consideration in designing the PV device and understanding the net shadowing effect of both the conductors and the conductive particle matrix. Example and non-limiting ranges of the conductive particle matrix optical area as a percentage of the solar active area include: 0.02% to 0.1%, 0.1% to 1%, 2% to 10%, 1% to 2%, 2% to 3%, 3% to 5%, 5% to 7%, and 7% to 10%. All described arrangements and percentages are non-limiting examples.

The schematic flow description which follows provides an illustrative embodiment of performing procedures for designing a PV element. The PV element, in certain embodiments, is usable as a portion of a PV device, such as a building integrated PV device. Operations illustrated are understood to be exemplary only, and operations may be combined or divided, and added or removed, as well as reordered in whole or part, unless stated explicitly to the contrary herein. Certain operations illustrated may be implemented by a computer executing a computer program product on a computer readable medium, where the computer program product comprises instructions causing the computer to execute one or more of the operations, or to issue commands to other devices to execute one or more of the operations.

Certain operations described herein include operations to interpret one or more parameters. Interpreting, as utilized herein, includes receiving values by any method known in the art, including at least receiving values from a datalink or network communication, receiving an electronic signal (e.g. a voltage, frequency, current, or PWM signal) indicative of the value, receiving a software parameter indicative of the value, reading the value from a memory location on a non-transient computer readable storage medium, receiving the value as a run-time parameter by any means known in the art, and/or by receiving a value by which the interpreted parameter can be calculated, and/or by referencing a default value that is interpreted to be the parameter value.

An example procedure includes an operation to interpret a first degradation characteristic of a nominal photovoltaic (PV) element having a conductor and a conductive layer with no conductive particle matrix therebetween. In certain embodiments, the first degradation characteristic represents a nominal case or a baseline case. The first degradation characteristic may be stored as a baseline and recalled when a PV element design optimization operation is performed. The example procedure further includes an operation to interpret a degradation characteristic function and a cost differential function of a PV element having a conductive particle matrix interposed between a conductor and a conductive layer. The degradation characteristic function and the cost differential function include functions of a design selection parameter of the conductive particle matrix.

An example design selection parameter includes a portion of individual conductor elements connected to the conductive particle matrix, for example whether one-third, one-half, or all of the individual conductor elements are to have conductive particle matrix portions positioned between the individual elements and the conductive layer. The listed portions of the individual conductor elements to be connected are non-limiting examples, and any set of portion values may be considered. Another example design selection parameter includes a fraction of a conductor-conductive layer apparent contact area having the conductive particle matrix positioned therebetween. Yet another example design selection parameter includes a material selection of the conductor, a material selection of the conductive particle matrix, and/or a particle size of conductive particles in the conductive particle matrix. The listed design selection parameters are non-limiting examples, and any parameter that is amenable to design change and cost/benefit analysis may be utilized as a design selection parameter.

The procedure further includes an operation to provide a PV element design in response to the first degradation characteristic, the degradation characteristic function, the cost differential function, and the design selection parameter. The degradation characteristic function and the cost differential function of the design selection parameter may be piecewise defined, continuously defined, and/or defined at two or more discrete values. Accordingly, the degradation characteristic function and the cost differential function may be determined at two or more values of the design selection parameter, and a determination of the PV element design may be made in response to the determined values. In one example, none of the selected values of the design selection parameter result in an improvement over the first degradation characteristic, and the PV element design does not include a conductive particle matrix. In certain embodiments, a cost-benefit analysis is made, and the PV element design includes the design characteristic value providing a best net present value. In certain embodiments, a criteria such as a lowest power output value after degradation determines the PV element design, for example where a threshold power output value is required for an application and only a subset of the potential designs can achieve the threshold power output value.

In certain embodiments, one or more characteristics of the system design are utilized to inform the degradation characteristic function and/or the cost differential function. An example consideration includes considering a shadowing effect of the conductive particle matrix, considering a shadowing effect of a combined conductive particle matrix and conductor system, considering a materials cost of the conductive particle matrix, considering a materials cost of a PV element manufactured according to the design selection parameter, considering a manufacturing cost of the conductive particle matrix, considering a manufacturing cost of a PV element manufactured according to a design selection parameter, considering the integrated power generated over time by the PV device, considering a lowest power generation amount at any time during a time of interest, and/or considering a differential system sizing value in response to the first degradation characteristic and the degradation characteristic function.

In one example, variable configurations and coverages of the conductive particle matrix provide variable resulting degradation characteristics and competing shadowing characteristics. It is a mechanical step for one of skill in the art, having the benefit of the disclosures herein, to determine the degradation characteristics for a finite number of configurations by determining data similar to that shown in Figs. 9-11, and to determine shadowing characteristics through simple geometric analysis for the finite number of configurations. In another example, varying materials in the conductive particle matrix provide variable resulting degradation characteristics and cost characteristics. It is a mechanical step for one of skill in the art, having the benefit of the disclosures herein, to determine the degradation characteristics for a finite number of particle materials in the conductive particle matrix by determining data similar to that shown in Figs. 9-11, and to determine cost parameters for those materials through normal engineering calculations.

In another example, the manufacturing cost of a particular conductive particle matrix formulation and deposition plan is readily determined, and can be compared to competing manufacturing plans, whether the competing manufacturing plans are other conductive particle matrix formulations and/or deposition plans, a simple conductor - adhesive system, or a full string-and-tab configuration. The manufacturing cost can include any relevant costs, including at least operational costs, facility acquisition costs, equipment acquisition and tooling costs, and/or environmental risk management costs. In certain embodiments, the manufacturing cost is directed to the differential cost of the entire PV element - for example a more robust conductive particle matrix formulation may allow for a cheaper conductor to be utilized, providing for an offset comparison that may allow optimization of the PV element value.

In another example, the integrated power over time is considered in determining the design selection parameter. For example, a more expensive option to manufacture (e.g. a complex layout of the conductive particle matrix) may be offset by improved power generation over the life of the PV device utilizing the PV element having the option. Additionally or alternatively, a more expensive material cost (e.g. a conductive particle matrix having silver coated copper particles rather than only copper particles) may be offset by improved power generation over the life of the PV device. In yet another example, the increased cost of providing the conductive particle matrix relative to a design having the conductor directly applied to the conductive layer may be offset by the improved power generation over the life of the PV device. The time horizon of the integrated power determination may be any selected value, including at least a regulated time period, a user-entered investment period, a warranty time period, and/or a scheduled product life time period.

In yet another example, a lowest power generation amount at any time during a time of interest may be considered. For example, certain applications may have a power requirement that must be met, or that will introduce negative externalities into the system if the power requirement is not met. For example, a remote application that requires a specified power threshold, and that will require installation of additional power lines and/or addition of a portable generator, etc. may have a minimum power requirement for the time period of interest. In the example, the lowest cost configuration among a number of configurations may be utilized as the selected value of the design selection parameter that meets the minimum specified power threshold. Additionally or alternatively, the cost of any negative externality, for example the cost of a standby power generation device, can be utilized as a consideration in determining the selected value of the design selection parameter.

In still another example, a differential system sizing value may be considered. For example, to achieve the power specifications of an application, several design selection parameter values may be considered, and where one of the design selection parameter. Accordingly, other costs due to system sizing may be considered in the cost differential function. An increased system size may increase the manufacturing cost through more materials, additional manufacturing time, and/or additional manufacturing equipment. Additionally or alternatively, external costs such as an application applied cost (e.g. application space may be limited or at a premium) may be included in the cost differential function.

Any numerical values recited in the above application include all values from the lower value to the upper value in increments of one unit provided that there is a separation of at least 2 units between any lower value and any higher value. As an example, if it is stated that the amount of a component or a value of a process variable such as, for example, temperature, pressure, time and the like is, for example, from 1 to 90, further including from 20 to 80, also including from 30 to 70, it is intended that values such as 15 to 85, 22 to 68, 43 to 51, 30 to 32 etc. are expressly enumerated in this disclosure. One unit is considered to be the most precise unit disclosed, such as 0.0001, 0.001, 0.01 or 0.1 as appropriate. These are only examples of what is specifically intended and all possible combinations of numerical values between the lowest value and the highest value enumerated are to be considered to be expressly stated in this disclosure in a similar manner.

Unless otherwise stated, all ranges include both endpoints and all numbers between the endpoints. The use of the terms "comprising" or "including" describing combinations of elements, ingredients, components or steps herein also contemplates embodiments that consist essentially of the elements, ingredients, components or steps. The use of the articles "a" or "an," and/or the disclosure of a single item or feature, contemplates the presence of more than one of the item or feature unless explicitly stated to the contrary.

Example embodiments of the present invention have been disclosed. A person of ordinary skill in the art will realize however, that certain modifications to the disclosed embodiments come within the teachings of this disclosure. Therefore, the following claims should be studied to determine the true scope and content of the invention.

## Claims

1. An article (100) of manufacture, comprising:
a photovoltaic (PV) element (102) having a conductive layer (106) positioned on a light-incident side of the PV element (102);
a conductor (204) electrically coupled to the conductive layer (106);
a conductive particle matrix (206) interposed between the conductor and the conductive layer (106) at a plurality of positions on the conductive layer (106);
a carrier film (110) positioned on the light-incident side of the PV element (102); and
a non-conductive adhesive (202), wherein the adhesive (202) and the conductor (204) are interposed between the carrier film (110) and the conductive layer (106).

2. The article of claim 1, wherein the conductive particle matrix (206) comprises a printed ink.

3. The article of any one of the preceding claims, wherein the conductive particle matrix comprises conductive particles, the conductive particles comprising at least one material selected from the materials consisting of: copper, silver, gold, silver coated copper, gold coated copper, gold coated silver, silver coated stainless steel, silver coated tin, and a silver coated metal, and a gold coated metal.

4. The article of any one of the preceding claims, wherein the conductor comprises at least one material selected from the materials consisting of: tin, aluminum, copper, indium, tin-plated copper, and a copper alloy.

5. The article of any one of the preceding claims, wherein the conductive particle matrix comprises a conductive ink, and wherein the conductor comprises a wire mesh having applied conductive ink thereto, and applied to the conductive layer.

6. The article of any one of the preceding claims, wherein the conductor comprises a plurality of conductive members, and wherein the conductive particle matrix is further interposed between the conductive layer and only a portion of the plurality of the conductive members.

7. The article of claim 6, wherein the portion comprises a value between one-tenth and nine-tenths, inclusive.

8. The article of any one of claims 1 through 5, wherein the conductive particle matrix is further interposed between the conductive layer and a first fraction of an area comprising a conductor-conductive layer apparent contact area.

9. The article of any one of the preceding claims, wherein an optical coverage area of the conductor comprises a fraction of an area comprising a solar active area of the PV element, the fraction comprising a fraction range selected from the fractional ranges consisting of:
between 2% and 3% of the solar active area, inclusive;
between 3% and 5% of the solar active area, inclusive;
between 5% and 7% of the solar active area, inclusive; and
between 7% and 10% of the solar active area, inclusive.

10. The article of claim 1, wherein a conductive particle matrix optical area of the conductive particle matrix comprises a fraction of a solar active area of the PV element, the fraction comprising a fraction range selected from the fractional ranges consisting of:
between 0.02% and 0.1% of the solar active area, inclusive;
between 0.1% and 1% of the solar active area, inclusive;
between 2% and 10% of the solar active area, inclusive;
between 1% and 2% of the solar active area, inclusive;
between 2% and 3% of the solar active area, inclusive;
between 3% and 5% of the solar active area, inclusive;
between 5% and 7% of the solar active area, inclusive; and
between 7% and 10% of the solar active area, inclusive.

11. The article of any one of the preceding claims, wherein the conductor comprises a physically continuous portion and wherein the conductive particle matrix is further interposed between the physically continuous portion and the conductive layer at a plurality of positions comprising physically discontinuous portions of the conductive particle matrix.

12. A method, comprising:
interpreting a first degradation characteristic of a nominal photovoltaic (PV) element having a conductor and a conductive layer with no conductive particle matrix therebetween;
interpreting a degradation characteristic function and a cost differential function of a PV element having a conductive particle matrix interposed between a conductor and a conductive layer, the degradation characteristic function and the cost differential function comprising functions of a design selection parameter of the conductive particle matrix; and
providing a PV element design in response to the first degradation characteristic, the degradation characteristic function, the cost differential function, and the design selection parameter.

13. The method of claim 12, wherein the providing includes at least one operation selected from the operations consisting of:
considering a shadowing effect of the conductive particle matrix;
considering a shadowing effect of a combined conductive particle matrix and conductor system;
considering a materials cost of the conductive particle matrix;
considering a materials cost of a PV element manufactured according to a design selection parameter;
considering a manufacturing cost of the conductive particle matrix;
considering a manufacturing cost of a PV element manufactured according to a design selection parameter;
considering integrated power generated over time;
considering a lowest power generation amount at any time during a time of interest; and
considering a differential system sizing value in response to the first degradation characteristic and the degradation characteristic function.

14. The method of any one of claims 12 and 13, wherein the design selection parameter comprises at least one design value selected from the design values consisting of:
a portion of individual conductor elements connected to the conductive particle matrix;
a fraction of a conductor-conductive layer apparent contact area interposed with the conductive particle matrix;
a material selection of the conductor;
a material selection of the conductive particle matrix; and
a particle size of conductive particles in the conductive particle matrix.

15. A building integrated photovoltaic (BIPV) module, comprising:
a photovoltaic (PV) element having a conductive layer positioned on a light-incident side of the PV element, a conductor electrically coupled to the conductive layer, a conductive particle matrix interposed between the conductor and the conductive layer at a plurality of positions on the conductive layer, a carrier film positioned on the light-incident side of the PV element, a non-conductive adhesive, wherein the adhesive and the conductor are interposed between the carrier film and the conductive layer;
a light-incident encapsulation layer positioned on the light incident side of the carrier film; and
a building side conductive layer, a building side conductor, and a building side encapsulation layer positioned on a building side of the PV element.

## Patentansprüche

1. Ein Herstellungsartikel (100), der Folgendes beinhaltet:
ein photovoltaisches (PV) Element (102) mit einer leitenden Schicht (106), die auf einer Lichteinfallseite des PV-Elements (102) positioniert ist;
einen mit der leitenden Schicht (106) elektrisch gekoppelten Leiter (204);
eine leitende Partikelmatrix (206), die an einer Vielzahl von Positionen auf der leitenden Schicht (106) zwischen den Leiter und die leitende Schicht (106) eingeschoben ist;
eine auf der Lichteinfallseite des PV-Elements (102) positionierte Trägerfolie (110); und
einen nichtleitenden Klebstoff (202), wobei der Klebstoff (202) und der Leiter (204) zwischen die Trägerfolie (110) und die leitende Schicht (106) eingeschoben sind.

2. Artikel gemäß Anspruch 1, wobei die leitende Partikelmatrix (206) eine gedruckte Tinte beinhaltet.

3. Artikel gemäß einem der vorhergehenden Ansprüche, wobei die leitende Partikelmatrix leitende Partikel beinhaltet, wobei die leitenden Partikel mindestens ein Material beinhalten, das aus den aus Folgendem bestehenden Materialien ausgewählt ist: Kupfer, Silber, Gold, silberbeschichtetem Kupfer, goldbeschichtetem Kupfer, goldbeschichtetem Silber, silberbeschichtetem Edelstahl, silberbeschichtetem Zinn und einem silberbeschichtetem Metall und einem goldbeschichteten Metall.

4. Artikel gemäß einem der vorhergehenden Ansprüche, wobei der Leiter mindestens ein Material beinhaltet, das aus den aus Folgendem bestehenden Materialien ausgewählt ist: Zinn, Aluminium, Kupfer, Indium, verzinntem Kupfer und einer Kupferlegierung.

5. Artikel gemäß einem der vorhergehenden Ansprüche, wobei die leitende Partikelmatrix eine leitende Tinte beinhaltet und wobei der Leiter ein Drahtnetz beinhaltet, auf das leitende Tinte aufgebracht ist und das auf die leitende Schicht aufgebracht ist.

6. Artikel gemäß einem der vorhergehenden Ansprüche, wobei der Leiter eine Vielzahl von leitenden Gliedern beinhaltet und wobei die leitende Partikelmatrix ferner zwischen die leitende Schicht und nur einen Teil der Vielzahl der leitenden Glieder eingeschoben ist.

7. Artikel gemäß Anspruch 6, wobei der Teil einen Wert zwischen einschließlich einem Zehntel und neun Zehnteln beinhaltet.

8. Artikel gemäß einem der Ansprüche 1 bis 5, wobei die leitende Partikelmatrix ferner zwischen die leitende Schicht und einen ersten Anteil einer Fläche, die eine augenscheinliche Kontaktfläche für den Leiter und die leitenden Schicht beinhaltet, eingeschoben ist.

9. Artikel gemäß einem der vorhergehenden Ansprüche, wobei eine optische Bedeckungsfläche des Leiters einen Anteil einer Fläche beinhaltet, die eine solaraktive Fläche des PV-Elements beinhaltet, wobei der Anteil einen Anteilsbereich beinhaltet, der aus den aus Folgendem bestehenden Anteilsbereichen ausgewählt ist:
zwischen einschließlich 2 % und 3 % der solaraktiven Fläche;
zwischen einschließlich 3 % und 5 % der solaraktiven Fläche;
zwischen einschließlich 5 % und 7 % der solaraktiven Fläche; und
zwischen einschließlich 7 % und 10 % der solaraktiven Fläche.

10. Artikel gemäß Anspruch 1, wobei eine optische Fläche der leitenden Partikelmatrix von der leitenden Partikelmatrix einen Anteil einer solaraktiven Fläche des PV-Elements beinhaltet, wobei der Anteil einen Anteilsbereich beinhaltet, der aus den aus Folgendem bestehenden Anteilsbereichen ausgewählt ist:
zwischen einschließlich 0,02 % und 0,1 % der solaraktiven Fläche;
zwischen einschließlich 0,1 % und 1 % der solaraktiven Fläche;
zwischen einschließlich 2 % und 10 % der solaraktiven Fläche;
zwischen einschließlich 1 % und 2 % der solaraktiven Fläche;
zwischen einschließlich 2 % und 3 % der solaraktiven Fläche;
zwischen einschließlich 3 % und 5 % der solaraktiven Fläche;
zwischen einschließlich 5 % und 7 % der solaraktiven Fläche; und
zwischen einschließlich 7 % und 10 % der solaraktiven Fläche.

11. Artikel gemäß einem der vorhergehenden Ansprüche, wobei der Leiter einen physisch zusammenhängenden Teil beinhaltet und wobei die leitende Partikelmatrix ferner an einer Vielzahl von Positionen, die physisch unzusammenhängende Teile der leitenden Partikelmatrix beinhalten, zwischen den physisch zusammenhängenden Teil und die leitende Schicht eingeschoben ist.

12. Ein Verfahren, das Folgendes beinhaltet:
Interpretieren einer ersten Degradierungscharakteristik eines nominalen photovoltaischen (PV) Elements mit einem Leiter und einer leitenden Schicht ohne dazwischenliegende leitende Partikelmatrix;
Interpretieren einer Degradierungscharakteristikfunktion und einer Kostendifferenzfunktion eines PV-Elements mit einer zwischen einen Leiter und eine leitende Schicht eingeschobenen leitenden Partikelmatrix, wobei die Degradierungscharakteristikfunktion und die Kostendifferenzfunktion Funktionen eines Designauswahlparameters der leitenden Partikelmatrix beinhalten; und
Bereitstellen eines PV-Element-Designs als Reaktion auf die erste Degradierungscharakteristik, die Degradierungscharakteristikfunktion, die Kostendifferenzfunktion und den Designauswahlparameter.

13. Verfahren gemäß Anspruch 12, wobei das Bereitstellen mindestens einen Vorgang umfasst, der aus den aus Folgendem bestehenden Vorgängen ausgewählt ist:
Berücksichtigen eines Beschattungseffekts der leitenden Partikelmatrix;
Berücksichtigen eines Beschattungseffekts eines kombinierten Systems von leitender Partikelmatrix und Leiter;
Berücksichtigen von Materialkosten der leitenden Partikelmatrix;
Berücksichtigen von Materialkosten eines gemäß einem Designauswahlparameter hergestellten PV-Elements;
Berücksichtigen von Herstellungskosten der leitenden Partikelmatrix;
Berücksichtigen von Herstellungskosten eines gemäß einem Designauswahlparameter hergestellten PV-Elements;
Berücksichtigen der über Zeit erzeugten integrierten Energie;
Berücksichtigen einer geringsten Energieerzeugungsmenge zu einem beliebigen Zeitpunkt während einer Zeit von Interesse; und
Berücksichtigen eines Differenzsystembemessungswertes als Reaktion auf die erste Degradierungscharakteristik und die Degradierungscharakteristikfunktion.

14. Verfahren gemäß einem der Ansprüche 12 und 13, wobei der Designauswahlparameter mindestens einen Designwert beinhaltet, der aus den aus Folgendem bestehenden Designwerten ausgewählt ist:
einem Teil individueller Leiterelemente, die mit der leitenden Partikelmatrix verbunden sind;
einem Anteil einer augenscheinlichen Kontaktfläche für Leiter und leitende Schicht, in den die leitende Partikelmatrix eingeschoben ist;
einer Materialauswahl des Leiters;
einer Materialauswahl der leitenden Partikelmatrix; und
einer Partikelgröße von leitenden Partikeln in der leitenden Partikelmatrix.

15. Ein Modul gebäudeintegrierter Photovoltaik (BIPV), das Folgendes beinhaltet:
ein photovoltaisches (PV) Element mit einer leitenden Schicht, die auf einer Lichteinfallseite des PV-Elements positioniert ist, einem elektrisch an die leitende Schicht gekoppelten Leiter, einer an einer Vielzahl von Positionen auf der leitenden Schicht zwischen den Leiter und die leitende Schicht eingeschobenen leitenden Partikelmatrix, einer auf der Lichteinfallseite des PV-Elements positionierten Trägerfolie,
einem nichtleitenden Klebstoff, wobei der Klebstoff und der Leiter zwischen die Trägerfolie und die leitende Schicht eingeschoben sind;
eine Lichteinfalleinkapselungsschicht, die auf der Lichteinfallseite der Trägerfolie positioniert ist; und
eine gebäudeseitige leitende Schicht, einen gebäudeseitigen Leiter und eine gebäudeseitige Einkapselungsschicht, die auf einer Gebäudeseite des PV-Elements positioniert sind.

## Revendications

1. Un article (100) de fabrication, comprenant :
un élément photovoltaïque (PV) (102) ayant une couche conductrice (106) positionnée sur un côté incident à la lumière de l'élément PV (102) ;
un conducteur (204) couplé électriquement à la couche conductrice (106) ;
une matrice de particules conductrices (206) intercalée entre le conducteur et la couche conductrice (106) au niveau d'une pluralité de positions sur la couche conductrice (106) ;
un film porteur (110) positionné sur le côté incident à la lumière de l'élément PV (102) ; et
un adhésif non conducteur (202), l'adhésif (202) et le conducteur (204) étant intercalés entre le film porteur (110) et la couche conductrice (106).

2. L'article de la revendication 1, dans lequel la matrice de particules conductrices (206) comprend une encre imprimée.

3. L'article de n'importe laquelle des revendications précédentes, dans lequel la matrice de particules conductrices comprend des particules conductrices, les particules conductrices comprenant au moins un matériau sélectionné parmi les matériaux consistant en : du cuivre, de l'argent, de l'or, du cuivre revêtu d'argent, du cuivre revêtu d'or, de l'argent revêtu d'or, de l'acier inoxydable revêtu d'argent, de l'étain revêtu d'argent, et d'un métal revêtu d'argent, et d'un métal revêtu d'or.

4. L'article de n'importe laquelle des revendications précédentes, dans lequel le conducteur comprend au moins un matériau sélectionné parmi les matériaux consistant en : de l'étain, de l'aluminium, du cuivre, de l'indium, du cuivre plaqué à l'étain, et d'un alliage de cuivre.

5. L'article de n'importe laquelle des revendications précédentes, dans lequel la matrice de particules conductrices comprend une encre conductrice, et dans lequel le conducteur comprend un grillage métallique sur lequel est appliquée une encre conductrice, et appliqué sur la couche conductrice.

6. L'article de n'importe laquelle des revendications précédentes, dans lequel le conducteur comprend une pluralité d'éléments conducteurs, et dans lequel la matrice de particules conductrices est en outre intercalée entre la couche conductrice et uniquement une portion de la pluralité des éléments conducteurs.

7. L'article de la revendication 6, dans lequel la portion constitue une valeur comprise entre un dixième et neuf dixièmes, inclus.

8. L'article de n'importe laquelle des revendications 1 à 5, dans lequel la matrice de particules conductrices est en outre intercalée entre la couche conductrice et une première fraction d'une zone comprenant une zone de contact apparente de couche conductrice par conducteur.

9. L'article de n'importe laquelle des revendications précédentes, dans lequel une zone de couverture optique du conducteur comprend une fraction d'une zone comprenant une zone active solaire de l'élément PV, la fraction comprenant une gamme de fractions sélectionnée parmi les gammes de fractions consistant en :
entre 2 % et 3 % de la zone active solaire, inclus ;
entre 3 % et 5 % de la zone active solaire, inclus ;
entre 5 % et 7 % de la zone active solaire, inclus ; et
entre 7 % et 10 % de la zone active solaire, inclus.

10. L'article de la revendication 1, dans lequel une zone optique de matrice de particules conductrices de la matrice de particules conductrices comprend une fraction d'une zone active solaire de l'élément PV, la fraction comprenant une gamme de fractions sélectionnée parmi les gammes de fractions consistant en :
entre 0,02 % et 0,1 % de la zone active solaire, inclus ;
entre 0,1 % et 1 % de la zone active solaire, inclus ;
entre 2 % et 10 % de la zone active solaire, inclus ;
entre 1 % et 2 % de la zone active solaire, inclus ;
entre 2 % et 3 % de la zone active solaire, inclus ;
entre 3 % et 5 % de la zone active solaire, inclus ;
entre 5 % et 7 % de la zone active solaire, inclus ; et
entre 7 % et 10 % de la zone active solaire, inclus.

11. L'article de n'importe laquelle des revendications précédentes, dans lequel le conducteur comprend une portion physiquement continue et dans lequel la matrice de particules conductrices est en outre intercalée entre la portion physiquement continue et la couche conductrice au niveau d'une pluralité de positions comprenant des portions physiquement discontinues de la matrice de particules conductrices.

12. Une méthode, comprenant :
l'interprétation d'une première caractéristique de dégradation d'un élément photovoltaïque (PV) nominal ayant un conducteur et une couche conductrice sans matrice de particules conductrices entre eux ;
l'interprétation d'une fonction caractéristique de dégradation et d'une fonction de différentiel de coût d'un élément PV ayant une matrice de particules conductrices intercalée entre un conducteur et une couche conductrice, la fonction caractéristique de dégradation et la fonction de différentiel de coût comprenant des fonctions d'un paramètre de sélection de conception de la matrice de particules conductrices ; et
le fait de fournir une conception d'élément PV en réponse à la première caractéristique de dégradation, la fonction caractéristique de dégradation, la fonction de différentiel de coût, et le paramètre de sélection de conception.

13. La méthode de la revendication 12, dans laquelle le fait de fournir inclut au moins une opération sélectionnée parmi les opérations consistant en :
la considération d'un effet d'ombrage de la matrice de particules conductrices ;
la considération d'un effet d'ombrage d'une matrice de particules conductrices et d'un système de conducteur combinés ;
la considération d'un coût de matériaux de la matrice de particules conductrices ;
la considération d'un coût de matériaux d'un élément PV fabriqué selon un paramètre de sélection de conception ;
la considération d'un coût de fabrication de la matrice de particules conductrices ;
la considération d'un coût de fabrication d'un élément PV fabriqué selon un paramètre de sélection de conception ;
la considération d'une puissance intégrée générée avec le temps ;
la considération d'une quantité de génération de puissance la plus basse à un moment quelconque durant une durée d'intérêt ; et
la considération d'une valeur de dimensionnement de système différentiel en réponse à la première caractéristique de dégradation et la fonction caractéristique de dégradation.

14. La méthode de n'importe laquelle des revendications 12 et 13, dans laquelle le paramètre de sélection de conception comprend au moins une valeur de conception sélectionnée parmi les valeurs de conception consistant en :
une portion d'éléments conducteurs individuels raccordés à la matrice de particules conductrices ;
une fraction d'une zone de contact apparente de couche conductrice conducteur intercalée avec la matrice de particules conductrices ;
une sélection de matériau du conducteur ;
une sélection de matériau de la matrice de particules conductrices ; et
une taille de particule des particules conductrices dans la matrice de particules conductrices.

15. Un module photovoltaïque intégré au bâti (BIPV), comprenant :
un élément photovoltaïque (PV) ayant une couche conductrice positionnée sur un côté incident à la lumière de l'élément PV, un conducteur électriquement couplé à la couche conductrice, une matrice de particules conductrices intercalée entre le conducteur et la couche conductrice au niveau d'une pluralité de positions sur la couche conductrice, un film porteur positionné sur le côté incident à la lumière de l'élément PV, un adhésif non conducteur, l'adhésif et le conducteur étant intercalés entre le film porteur et la couche conductrice ;
une couche d'encapsulation incidente à la lumière positionnée sur le côté incident à la lumière du film porteur ; et
une couche conductrice côté bâti, un conducteur côté bâti, et une couche d'encapsulation côté bâti positionnés sur un côté bât de l'élément PV.
